# EUROPEAN PATENT APPLICATION

(11) **EP 3 035 404 A1**
(43) Date of publication of application: **22.06.2016**
(21) Application number: 14198191.0
(22) Date of filing: 16.12.2014
(51) Int. Cl.: H01L 51/52

(54) **Barrier foil comprising an electrical circuit**

(71) Applicant: Nederlandse Organisatie voor toegepast- natuurwetenschappelijk onderzoek TNO, 2595 DA 's-Gravenhage (NL); Philips Lighting Holding B.V., 5656 AE Eindhoven (NL)
(72) Inventor: Mandamparambil, Rajesh, 2595 DA Den Haag (NL); Lifka, Herbert, 5656 AE Eindhoven (NL); Unnikrishnan, Sandeep, 2595 DA Den Haag (NL)
(74) Representative: V.O.

(57) **Abstract**

Method and system for providing a barrier foil (10) comprising an electrical circuit. A barrier foil (10) comprises a layered structure comprising an organic layer (12) sandwiched between barrier layers (11, 13). A sealing material (17m) is deposited into an elongated groove (16) that is cut in the barrier foil (10). The sealed groove (17) and the barrier layers (11, 13) enclose organic material (12m) in at least part of the organic layer (12) and are adapted for preventing external moisture and/or oxygen (19) from reaching the organic material (12m). The sealing material (17m) comprises an electrically conductive material forming the electrical circuit.

## Description

### TECHNICAL FIELD AND BACKGROUND

The present disclosure relates to a barrier foil comprising an electrical circuit, and a method and system for providing the same.

Barrier foils find application in the production of device stacks for protecting sensitive components or materials from environmental influences. In one example, a device structure is sandwiched between barrier foils to prevent moisture and/or oxygen from seeping into the device structure. The device structure may e.g. comprise one or more organic layers forming an organic light emitting device (OLED), organic photovoltaic device (OPV), or other moisture and/or oxygen sensitive component. Large batches of device stacks may conveniently be produced in a roll-to-roll (R2R) or roll-to-sheet (R2S) process. Such a process typically involves providing a continuous substrate known as a 'web' and passing this substrate through various production processes, e.g. involving deposition of various material layers on the substrate. In one example, a substrate may form a continuous barrier foil comprising a continuous layered structure with an organic layer sandwiched between barrier foils.

A busbar is an electrically conducting structure or circuit, e.g. strip or bar, comprising a material with relatively high conductivity to facilitate a substantial current throughput in an electrical circuit. To achieve high current, it is also desired to provide the busbar with a relatively large cross-section. In one example, a busbar is electrically connected to a circuit electrode to improve electrical access and/or conductivity to the electrode. The electrode may e.g. comprise a device layer having relatively low conductivity. The busbar can be in direct contact with the electrode, or connected via a shunt (short circuit) to carry electricity therein between. Advantageously, the busbar can allow electrical access also at a distance from the electrode without substantially increasing electrical resistance. This can allow greater design freedom for connecting a power source or drain to the circuit.

When depositing electrically conducting structures, e.g. circuit lanes, on a barrier foil it can be difficult to achieve a desired bonding strength between the circuit lane and the barrier foil. For example the material of the barrier foil may form a relatively weak bond with the material of the conducting structure. This can be especially the case when depositing a relatively large cross-section circuit, e.g. busbar, onto the barrier foil. For some materials, bonding may be improved by heating the material. However, this may also damage the barrier foil and thus deteriorating its barrier properties.

It is desired to improve the bonding between the electrically conducting structure and the barrier foil without deteriorating the function of the barrier foil.

### SUMMARY

In a first aspect, there is provided a method for providing a barrier foil comprising an electrical circuit. The method comprises providing the barrier foil comprising a layered structure comprising an organic layer sandwiched between barrier layers. The method further comprises partially cutting through the barrier foil forming an elongated groove from one face of the barrier foil into the barrier foil. The method further comprises depositing a sealing material into the elongated groove thus forming a sealed groove. The sealed groove and the barrier layers are arranged for enclosing organic material in at least part of the organic layer. The sealed groove and the barrier layers are adapted for preventing, in use, external moisture and/or oxygen from reaching the organic material. The sealing material comprises an electrically conductive material forming the electrical circuit.

By cutting into the barrier foil, the organic layer may become exposed to external moisture and/or oxygen. By filling the groove with sealing material, this exposure may be alleviated. By using a conductive sealing material, the filled groove can form part of an electrical circuit. By depositing the electrically conducting sealing material into a groove of the barrier foil, the bonding can be improved, e.g. compared to depositing material on top of the foil. For example, a contact surface between the conductive material and the foil is increased by burying the material at least partially into the foil. Also the contact can formed with an additional type of material, e.g. the organic material inside the barrier foil. The cross-section surface or diameter of the circuit lane formed by the electrically conducting sealing material in the groove can be larger, with minimal protrusion from a face of the foil. This can allow improved deposition of further layers on top without interruption by the conductive lane. By allowing a larger cross-section of the conductive lane, the conductive properties can be improved. For example, the conductive circuit part formed by the sealed groove can function as a busbar.

The electrical circuit formed by the sealed groove can be connected to further electrical structures and layers, either directly or through intermediate conductive structures. For example, an electrically conducting shunt can be applied on top of the foil, wherein the shunt is electrically connected to the sealing material. By connecting the sealed groove with a shunt, the electrical circuit can be further built on top of the foil, e.g. in further layers deposited thereon. By providing a shunt connecting to the sealing material, the sealed groove may act as busbar to provide a better connection, e.g. an electrode layer. This may improve design freedom to provide a freeform foil. For example an electrode layer of a device structure on the foil is electrically connected to the sealing material. When sealing a device structure against external moisture, a part of an electrode layer may extend from underneath the sealing to provide electrical contact to an external power source or drain. By connecting such part to the electrically conducting sealing material, the access to the electrode can be improved.

By cutting the groove entirely through the organic layer and depositing the sealing material therein, the organic material can be further protected from exposure to moisture and/or oxygen migrating through the organic material. Advantageously, the sealed conducting groove can be formed alongside a predefined perimeter of a foil segment. When the foil segment is cut, the exposed organic layer at a side of the foil can be effectively protected by the sealed groove extending through the organic layer. It is noted WO2014/011044 also describes a sealed groove to prevent exposure of an organic layer. However, this prior art is not concerned with forming an electrical circuit by means of the sealed groove. For example, this prior art describes that a sealing material used for filling a groove through the device stack does not comprise conductive material, to prevent short-circuiting of the device stack.

In the present disclosure, preferably the sealing material has a high electric conductivity to form part of the electrical circuit, e.g. a bus bar. For example, the electric conductivity (σ) of the sealing material is preferably more than 10⁵ siemens per metre (S/m), preferably more than 10⁶ siemens per metre, preferably more than 5*10⁶, or even more, for example between 10⁵ to 10⁸ siemens per metre. The higher the conductivity, the better the sealed groove can function e.g. as a busbar. The conductive properties of the sealed groove can also be improved by having a relatively large cross-section. Preferably the electrical circuit formed by the sealed groove has a cross-section surface (transverse to the groove length) of more than 0.1 square millimetre, preferably more than 0.2 square millimetre, preferably more than 0.5 square millimetre, e.g. between 0.1 and 20 square millimetre. Correspondingly, for example a cross-section diameter of a conducting groove can be between 0.5 and 10 mm.

Preferably solder is used as sealing material to fill the groove and form the electrical circuit. Solder is a metal alloy, e.g. comprising a combination of two or more metals such as tin, lead, copper, silver, bismuth, indium, zinc, antimony, and/or traces of other metals. Preferably, the melting point of the solder is relatively low, e.g. low enough to allow deposition and/or reflowing of the solder material without damage to the foil. For example a melting point of the solder is preferably between 90 to 300 °C. It will be appreciated that solder can provide synergetic advantages of a good barrier, a good conductor, and good bonding (e.g. by reflowing), especially when using also wetting layer.

To improve contact and/or bonding with the groove, a wetting material can be optionally applied in or around the groove before applying the sealing material. For example, the wetting material may comprise a seed layer, e.g. comprising silver (Ag). The silver seed layer can also be used advantageously in combination with solder. The seed and/or sealing material can e.g. be applied using a non-contact method e.g. laser induced forward transfer (LIFT). Advantageously, the solder material can be reflowed after deposition to further improve bonding.

When cutting a groove into the foil, it is sometimes found that cracks may develop in the barrier layer on top. By cutting a shallow groove next to the deeper groove to be sealed, the crack formation may be stemmed. Preferably, the shallow groove is applied only in the barrier layer, while the deeper groove is cut partially or fully through the organic layer. The sealing material can be applied to both the deeper groove and the shallow groove to seal the organic material from external influence. For example a seed layer and/or solder layer can be applied into the deeper groove as well as cover the adjacent shallow groove. To prevent crack formation in either direction, the shallow grooves can be applied on either side of the deeper groove. Alternatively, e.g. if the foil is cut on one side of the foil, a shallow groove can be applied only on the inside direction of the sealed groove away from the cut edge of the foil. Preferably, the shallow groove or grooves are applied before cutting the deeper groove, to prevent already crack formation during the cutting. Sealing the deeper and shallow cuts can be advantageously achieved by using solder as the sealing material. For example, the solder can be reflowed to form a relatively wide seal over the adjacent cuts.

To provide a freeform trajectory of the grooves and/or foil perimeter, preferably, a laser is used for cutting, e.g. by ablating the material of the foil. For example, a laser is tuned in wavelength, intensity, and timing for ablating the organic layer while leaving at least part of the continuous barrier foil in a path of the laser intact. Alternatively, cutting e.g. the foil can also be performed e.g. by contact with a cutting tool.

In a second aspect, there is provided a system providing a barrier foil comprising an electrical circuit. The system comprises a foil providing means, a layer deposition means, a groove forming means, a groove sealing means, and a controller. The controller is arranged and programmed for controlling the foil providing means for providing a foil substrate. The controller is further arranged and programmed for controlling the layer deposition means for depositing a layered structure on the foil substrate. The layered structure comprises an organic layer sandwiched between barrier layers forming the barrier foil. The controller is further arranged and programmed for controlling the groove forming means for partially cutting through the barrier foil forming an elongated groove into the barrier foil. The controller is further arranged and programmed for controlling the groove sealing means for depositing a sealing material into the elongated groove thus forming a sealed groove. The sealed groove and the barrier layers are arranged for enclosing organic material at least part of the organic layer and adapted for preventing, in use, external moisture and/or oxygen from reaching the organic material. The groove sealing means comprises a supply with an electrically conductive material as the sealing material for forming the electrical circuit by means of the deposited sealing material.

The system may produce barrier foils with circuit parts that also form a seal against environmental influences such as moisture and/or oxygen. Advantages of the method according to the first aspect may similarly apply to the system according to the second aspect. The system may perform embodiments of the method as described herein, optionally with additional hardware. For example, the system may further comprise a shunt deposition means, wherein the controller is further arranged for controlling the shunt deposition means for depositing an electrically conducting shunt on top of the foil wherein the shunt is electrically connected to the sealing material. For example, the system may further comprise a foil cutting means, wherein the controller is arranged for controlling the groove forming means to form the elongated groove extending alongside a predefined segment perimeter on the barrier foil, the elongated groove extending from one face of the barrier foil all the way through at least the said organic layer; and controlling the foil cutting means for cutting through the barrier foil along the segment perimeter, wherein the sealed groove formed parallel to the predefined segment perimeter is adapted for preventing, in use, external moisture and/or oxygen from reaching the organic material when the barrier foil segment is cut along the pre-defined segment perimeter through the barrier foil.

In a third aspect, there is provided barrier foil comprising a layered structure. The layered structure comprises an organic layer sandwiched between barrier layers. The barrier foil segment comprises a sealed groove alongside a perimeter of the barrier foil. The sealed groove is formed by an elongated groove extending partially through the barrier foil segment from a face of the barrier foil. Preferably, the groove extends all the way through at least the organic layer. The elongated groove is filled with a sealing material. The sealed groove and the barrier layers are arranged for enclosing organic material in at least part of the organic layer and adapted for preventing, in use, external moisture and/or oxygen from reaching the organic material. The sealing material comprises an electrically conductive material forming an electrical circuit.

This barrier foil according to the third aspect may be conveniently produced by the method according to the first aspect or the system according to the second aspect. Advantages may include a barrier foil with a circuit that is more durable and/or cheaper to produce than known barrier foils. The barrier foil may find application in building a circuit, e.g. as part of a foil based organic light emitting device (OLED) or organic photovoltaic device (OPV). For example the barrier foil may comprise one or more electro-optical layers disposed on a face of the barrier foil. Advantageously the barrier foil can be configured to seal the electro-optical layers at least from one side for preventing external moisture and/or oxygen from reaching the electro-optical device structure. At the same time the sealing material can form a part of the electrical circuit, e.g. a busbar, that is electrically connected to the electro-optical device structure.

### BRIEF DESCRIPTION OF DRAWINGS

These and other features, aspects, and advantages of the methods, systems, and devices will become better understood from the following description, appended claims, and accompanying drawing wherein:
FIG 1 shows a schematic embodiment of a method for providing an electrical circuit on a barrier foil;
FIGs 2A and 2B show schematic cross-section views of embodiments of a barrier foil with integrated electrical circuit connected to an electrical device stack on top of the foil;
FIG 3 shows a schematic top view of a foil segment with electrical connections applied to the circuit;
FIG 4A shows schematic embodiment of a method for cutting into a barrier foil;
FIG 4B shows a schematic embodiment for filling cuts in the barrier foil;
FIG 5 shows a system for providing an electrical circuit on a barrier foil.

### DESCRIPTION OF EMBODIMENTS

Patterning of flexible barrier substrates may enable the production of customized flexible light emitting as well as photovoltaic devices. Barrier foils find application in the production of device stacks for protecting sensitive components or materials from environmental influences. Large batches of device stacks may conveniently be produced in a roll-to-roll (R2R) or roll-to-sheet (R2S) process. To transform a continuous barrier foil into useable device components, there is sometimes a need for dividing the continuous barrier foil into segments. However, simply cutting the continuous barrier foil may result in exposure of the organic layer at edges of the segment where the foil is cut. There are challenges involved in customization. One challenge is achieving a hermitical seal of the processed flexible barrier substrates. The cutting the barrier involves disturbing the inorganic layers of the barrier stack leading to collateral damage of the device. Another challenge is electrical contacting which should preferably not be performed on the barrier area, since it might introduce defects due to mechanical, chemical, or thermal damage to the barrier area.

One of the techniques to alleviate this problem may comprise filling the processed barrier region with metals such as solder to achieve hermitical sealing. Along with providing the hermitical seal, another challenge lies in envisaging the electrode contacts for distribution of the current to power up the devices or retrieving the voltage generated. Solder also provides an advantage that it will have less pinholes, forms a clean and uniform layer. One embodiment may comprise one or more of the following steps: providing a uniformly deposited ITO/barrier substrate; free form the barrier substrate by using laser; non-contact laser based deposition of both wetting and solder in the trenches to form hermitical seal as well as embedded contact with high aspect ratio. deposition of shunt lines, by laser or other techniques. Some of the described techniques may allow the formation of a continuously coated barrier stack on film and subsequent free-form patterning of it already integrating the edge-barrier and contact pads as well as electrode shunting. The shunting process in this way may enable a lower electrode resistance and also smaller contact areas. This enables ITO only devices and more light emitting area. Compared to other techniques for free forming of the barrier, e.g. inkjet printing, the present disclosure may provide relatively low cost and improve customization at the customer side. Compared to another technique for electrical contacting, e.g. a photolitho process, the present disclosure may provide more freedom of design. In one embodiment a laser/blade is used to process the foil, by cutting in customised shapes. The barrier substrates is encapsulated for example as follows. The top barrier layer (e.g. SiN) is prone to cracks when the barrier is completely cut through. In order to prevent this, the crack limiting structures are scribed on the top SiN layer. Then the isolation scribe is made by using a laser in between the crack limiting scribes. One can stop in the bottom nitride, or go through this nitride. This step is followed by the deposition of a solder wetting layer (e.g. Ag paste). Oven/laser sintering of the wetting layer may be carried out and the solder layer is deposited by using laser followed by reflowing forming a self aligned encapsulation ring. After the processing and edge sealing of substrates, the same encapsulation rings can be used as electrode contact structures eliminating the need of complicated designs for the same.

Unless otherwise defined, all terms (including technical and scientific terms) used herein have the same meaning as commonly understood by one of ordinary skill in the art to which this invention belongs as read in the context of the description and drawings. It will be further understood that terms, such as those defined in commonly used dictionaries, should be interpreted as having a meaning that is consistent with their meaning in the context of the relevant art and will not be interpreted in an idealized or overly formal sense unless expressly so defined herein. In some instances, detailed descriptions of well-known devices and methods may be omitted so as not to obscure the description of the present systems and methods. Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise. All publications, patent applications, patents, and other references mentioned herein are incorporated by reference in their entirety. In case of conflict, the present specification, including definitions, will control.

The term "foil" refers to a sheet comprising one or more layers of material. Preferably, the foil is flexible such that it can be used in a roll-to-roll (R2R) or roll to sheet (R2S) manufacturing process. For such purpose, a foil may be considered flexible if it can be rolled or bent over a radius of curvature of 50 cm or less without losing its essential functionality, e.g. barrier and/or electronic functionality. Alternatively, or in conjunction a foil may be considered flexible if it has a flexural rigidity smaller than 500 Pa·m3.

The term "barrier foil" refers to a foil that functions as a barrier against environmental influences such as moisture and/or oxygen. The barrier foil may be used to enclose sensitive materials or components thereby separating them from said environmental influences. The barrier foil may comprise one or more barrier layers having a low transmission rate for said environmental influences. The barrier layers are typically formed by inorganic material. A transmission rate of a barrier layer may be considered low if it significantly delays deterioration of the underlying layer as a result of the influence of external moisture and/or oxygen. For present applications an intrinsic water vapor transmission rate (WVTR) under standard atmospheric conditions below 10⁻⁵ grams of water per day per square meter of the barrier may be considered low. Alternatively or in addition, for present applications an oxygen transmission rate below one milliliter (ml) of oxygen per day per square meter of the barrier may be considered low.

The term "in use", e.g. with reference to the use of the barrier foil or barrier layer, intends to imply normal or average conditions wherein a user, e.g. end-user, would use the foil or a device comprising the foil. In such a situation the foil may be subjected to normal (average) ambient or atmospheric conditions such as humidity, oxygen-level, pressure, temperature, etc. A barrier layer arranged for preventing, in use, moisture and/or oxygen from reaching the organic layer is thus suitable to prevent or substantially delay external ambient moisture and/or oxygen from reaching the organic layer, which may otherwise damage the organic layer. In this way the life-time of the organic layer and/or the device may be extended during normal use, e.g. by a factor of 2 or more, preferably by a factor of 10 or more. Of course, the sealing properties of the barrier layer may comply to more stringent conditions, e.g. being also suitable for more extreme conditions such as using the device or foil under water. Also it is noted that e.g. the temperature of the foil may depend on its use, e.g. the device comprising the foil may heat the foil which may have an adverse effect on the barrier properties of the foil.

In a typical production process, the barrier layers may be separated by one or more planarization layers that may provide a planarized surface for depositing a barrier layer thereon. The planarization layer may comprise organic material. In one example an organic coating for planarization (OCP) is sandwiched between two barrier layers to form a single-dyad barrier foil. Organic material in the barrier foil itself is preferably also protected from said environmental influences. Alternatively or in addition, the organic material may itself function as part of the barrier, e.g. comprising moisture getters. When cutting a barrier foil into smaller barrier foil segments, it may be preferable to seal the cut edges of the segments before exposing these to the environmental influences.

The term "continuous" as in "continuous foil" refers to the fact that the foil comprises one or more continuous or non-segmented layers. The continuous layers may possess a high degree of translation symmetry along one or more of the dimensions of the foil. A continuous foil may also comprise a combination of continuous and non-continuous layers. When cutting a continuous foil, one or more of the continuous layers may get exposed at the cut edges. In some cases it is preferred to prevent this exposure by sealing the edges, e.g. in the case of cutting a continuous barrier foil. Before cutting, the continuous foil may be divided into foil segments.

A continuous layer may be formed e.g. in a continuous production process. A continuous foil may be particularly suitable to be produced in a R2R process or further processed in a R2R or R2S process. In one example, a substrate is supplied from a first roll and passed through a layer deposition process to form a continuous layer on the substrate before being rolled back up into a second roll (R2R).

A non-continuous layer may be formed e.g. in a production process involving discrete steps. In one example, a continuous foil is supplied from a roll and passed through a pattern deposition apparatus which applies discrete patterns, e.g. circuitry lanes, onto the continuous foil. In another example, discrete components may be placed on the continuous foil. Alternatively or in addition, the continuous foil may be cut into discrete sheets (R2S) wherein each sheet forms a device component.

A typical barrier layer may comprise Silicon Nitride ("SiN"), e.g. having a layer thickness between 50-200 nm. Also any other suitable material and layer thickness, known to the skilled artisan, may be used for forming a barrier layer with desired characteristics with respect of water vapor and/or oxygen transmission. A typical technique for depositing the barrier layer onto a substrate, e.g. a foil, may comprise using plasma enhanced chemical vapor deposition (PECVD). Also any other suitable technique known to the skilled artisan may be used for depositing a barrier layer. When using such a deposition technique it may be preferred to provide a smooth substrate so as to avoid irregularities in the deposited layer. A planarization layer may be provided on the substrate to provide a smooth surface. The planarization layer may comprise organic material, e.g. a UV curable acrylate. A planarization layer of an organic material is also referred to as an organic coating for planarization (OCP). In addition to providing a planarization layer between the barrier layers, additional planarization layers may be provided, e.g. between a substrate and a barrier layer. OCP layer may typically have a layer thickness between 5-20 µm. Also other suitable planarization layers materials and/or layer thicknesses, known to the skilled artisan, may be used. It may be preferred to prevent moisture from seeping into the OCP layer, e.g. to prevent deformation and/or delaminating of barrier layers.

In one example, a single-dyad barrier foil comprises layers of SiN - OCP -SiN. The barrier foil pattern may be customized to suit the needs, e.g. of a custom sized OLED or display, which are processed on it. The production of barrier foils may be up scaled using R2R mass-production on an industrial scale. In such a scenario the barrier film is continuously processed on a substrate roll. During mass production of the barrier stack, unpatterned coating of the OCP may be more commercially viable than the customized printing or patterning of the OCP. Traditionally, the OCP layer is patterned to prevent side leakage. However, in a scenario wherein a company wants to produce barrier foils in a roll-to-roll fashion e.g. for supplying OEM customers, this company typically needs to know the device lay-out of their OEM customers beforehand, making this commercially a difficult business case. To make the production of OLEDs economical, a roll-to-roll continuous coating approach is preferred. In such an approach, all the layers of an OLED or OPV device are continuously deposited on a barrier foil and finally encapsulated. Optionally, the encapsulation can be done by laminating another barrier foil or a metal foil on the device. Apart from finding a suitable approach towards cutting, sealing the cut edge of the OLED, OPV or barrier stacks is also a challenge. An advantageous approach towards sealing and cutting of the aforementioned stacks is also described herein.

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. The description of the exemplary embodiments is intended to be read in connection with the accompanying drawings, which are to be considered part of the entire written description. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

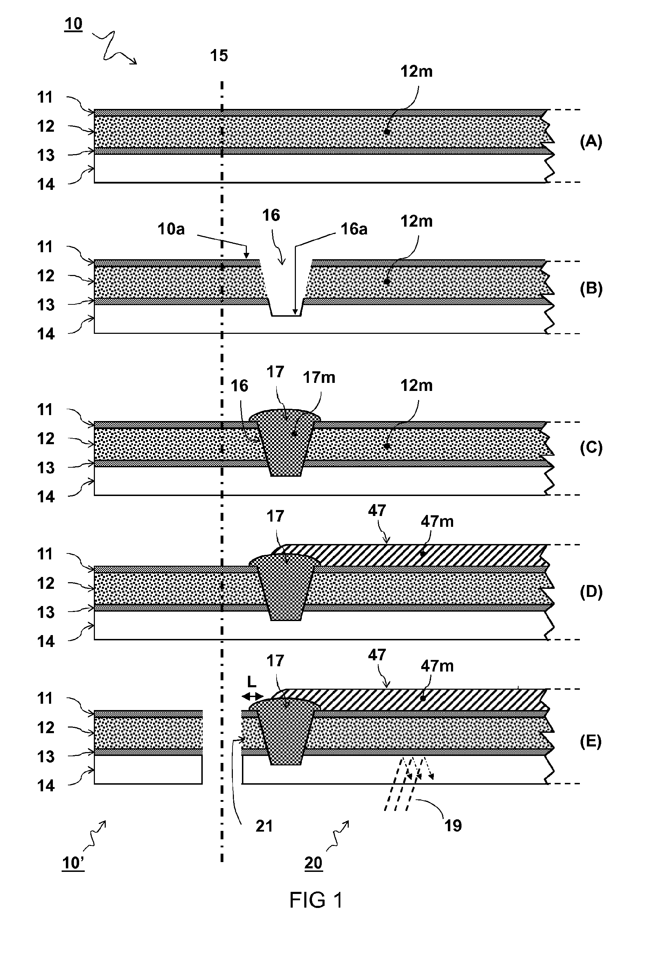

FIG 1 shows an embodiment of a method for providing a circuit on and/or partially in a barrier foil 10 and/or optionally cutting the foil. Cross-sectional views of the foils are schematically shown as steps A - E.

Step (A) comprises providing the barrier foil 10 comprising a layered structure comprising an organic layer 12 sandwiched between barrier layers 11, 13.

Step (B) comprises partially cutting through the barrier foil 10 forming an elongated groove 16 from one face 10a of the barrier foil 10 into the barrier foil 10. In one embodiment, the partially cutting the barrier foil 10 to form the elongated groove is performed by irradiation of the barrier foil 10 with a laser 80 configured to provide a free form trajectory of the groove in the barrier foil 10.

Step (C) comprises depositing a sealing material 17m into the elongated groove 16 thus forming a sealed groove 17. The sealed groove 17 and the barrier layers 11, 13 are arranged for enclosing organic material 12m in the organic layer 12 or at least in a part of the organic layer enclosed by the sealed groove 17 and the barrier layers 11, 13. These parts are thus adapted for preventing, in use, external moisture and/or oxygen 19 from reaching the organic material 12m. Advantageously, the sealing material 17m comprises an electrically conductive material forming the electrical circuit.

In one embodiment, the sealing material 17m has a relatively high electric conductivity, e.g. more than 10⁶ siemens per metre (S/m), typically more than 5*10⁶ siemens per metre. In one embodiment, the electrical circuit forms a busbar, i.e. electrical circuit lane having relatively high electrical conductivity. In one embodiment, the sealed groove 17 has a cross-section surface between 0.1 and 20 square millimetre (mm²). In one embodiment, the sealing material 17m comprises solder. In one embodiment, the applying of the sealing material comprises reflowing a solder material in the groove. In one embodiment, the filling of the barrier foil 10 to form the sealed groove is performed by laser induced forward transfer. Advantageously, the same laser can be used for cutting and filling the groove.

In one embodiment as shown in step (C) of this figure, the elongated groove 16 is overfilled with the sealing material 17m. As can be seen, this may result in a 'mushroom' shaped seal 17, wherein the top 17t of the seal 17 partly overhangs the top barrier layer 11. This configuration may have an advantage of providing a longer path length for moisture and/or oxygen to reach the enclosed organic material 12m, especially via the edges of the seal 17. Alternatively, the groove can also be filled just up to the top barrier layer. This can have the advantage of providing a conductive track that is completely buried in the foil. Accordingly, further layers can be added on top without interference from any protruding elements.

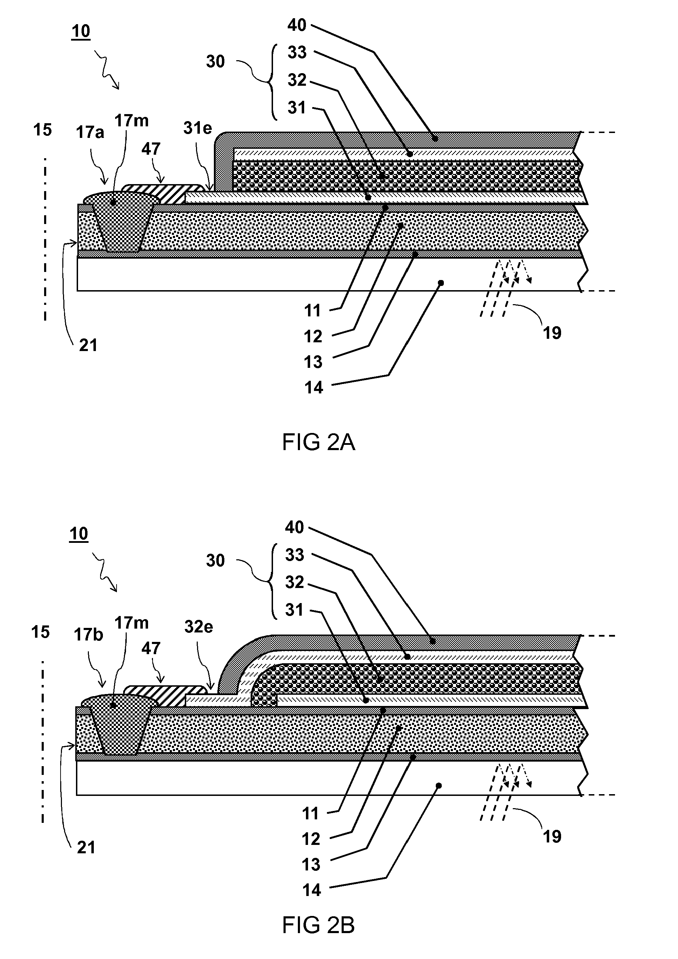

In the embodiment shown, the groove is cut all the way through the organic layer and also the bottom barrier layer 13. This can have the advantage that the organic layer is well sealed also from the side. In another embodiment (e.g. shown in FIGs 2A and 2B) Alternatively, the bottom barrier layer 13 is kept intact. In this way moisture and/or oxygen may also be prevented from reaching the organic material 12m via the bottom substrate 14. In yet another embodiment (not shown), the groove 14 can be dug only partway through the organic layer 12, e.g. to form an electric circuit in the groove without cutting the barrier foil along the perimeter 15 (i.e. omitting step E).

Step (D) comprises optional application of an electrically conducting shunt 47 on top of the foil 10. The shunt 47 is electrically connected to the sealing material 17m. Preferably, as shown, the shunt is applied to the foil on top of the sealing material, i.e. after the groove is sealed. Alternatively, the shunt can also be applied preceding step the cutting and/or filling of the groove (step A or B). The application of the shunt 47 can also be performed after further device structures are applied onto the foil. The further device structures can also be in direct electrical contact with the sealing material, thereby obviating the need for a separate shunt.

Step (E) comprises optional cutting of the barrier foil along a predefined segment perimeter 15. In one embodiment, the elongated groove 16 extends alongside the predefined segment perimeter 15 on the barrier foil 10, the elongated groove 16 extending from one face 10a of the barrier foil 10 all the way through at least the organic layer 12. By cutting the the continuous barrier foil 10 along the segment perimeter 15 next to the sealed groove, a separate barrier foil segment 20 is obtained that is sealed from the external environment by the barrier layers 11, 13 and the sealed groove 17. In one embodiment (not shown), the cutting through the continuous barrier foil 10 along the predefined segment perimeter 15 is performed during or before the sealed grooves 17 are applied. If cutting precedes sealing, it may be preferred to keep the time between these steps as short as possible to prevent environmental influences from degrading the exposed parts of the foil. In another embodiment, the continuous barrier foil 10 divided by the sealed grooves 17 is kept in one piece, i.e. not cut up. The divided continuous barrier foil 10 may thus be used for further continuous processing or to be stored on roll.

The term "predefined" as used in "predefined segment perimeter" refers to the fact that the absolute or relative position of the segment perimeter is determined at the moment that the grooves are applied, e.g. the segment is already cut or an indication of where the segment is to be cut may be established e.g. relative to the sealed groove. The predefined segment perimeter may e.g. depend on the size and shape of a device that is to be manufactured with the segment perimeter. In a production system a segment perimeter may be predefined by a controller controlling the cutting and/or sealing process. Said controller may e.g. comprise a memory with instructions for cutting the foil in a certain shape and/or with a certain distance interval.

In one embodiment the predefined segment perimeter 15 is arranged at a distance L from the sealed groove 17, between the sealed groove 17 and a remnant 10' of the continuous barrier foil 10 from which the barrier foil segment 20 is to be cut. The distance L is preferably as small as possible so as not to waste material of the foil. On the other hand, the distance should be large enough so as not to damage the seal. By cutting the barrier foil at a distance from the sealed groove, damage to the sealed groove as a result of the cutting process may be prevented. Seepage of moisture or oxygen from the cut sides of the barrier foil segment into the organic layer of the barrier foil segment may be prevented by the sealed groove therein between. This may improve yield of the sealed foil segments. The distance L may depend on the foil cutting means, e.g. the spot size of a cutting laser or the thickness of a cutting blade. Typically, L may preferably be in the range of 10 - 500 µm.

In the shown embodiment, the continuous barrier foil 10 further comprises a substrate 14 for carrying the other layers. The substrate 14 may e.g. comprise a flexible foil. Typical materials used for a flexible substrate foil may include one or more of polyethylene terephthalate (PET), polyethylene naphtalate (PEN), polyetheretherketone (PEEK), and polycarbonate. The substrate 14 may have a typical thickness of 25-200 µm. Alternatively, to being flexible, the substrate 14 may also be non-flexible or rigid, e.g. a glass plate. Alternative to using a substrate, the layers 11, 12, and 13 may be self-supporting not requiring a substrate. In one example, the substrate 14 may be peeled off either before applying the presently disclosed method for applying the circuit or after.

Whereas it is shown in this and other embodiments that the entire groove 16 is filled with sealing material 17m, alternatively the filling may be stopped when the sealing layer is thick enough to form sufficient protection against moisture and/or oxygen. In addition, while the shown embodiment comprises a single dyad barrier formed by an organic layer 12 sandwiched between barrier layers 11 and 13, this configuration may be expanded with additional organic and barrier layers, forming what is referred to as a multi-dyad structure. For example on top of the barrier layer 11 there may be another organic layer and top of that another barrier layer. Thus a structure may be formed comprising the layers barrier-organic-barrier-organic-barrier. This structure may be further expanded. The more layers are provided, the better may be the barrier function. Accordingly, in a preferred there is provided a barrier foil comprising a layered structure comprising two or more organic layers sandwiched between barrier layers wherein the two or more organic layers are interposed by additional barrier layers. Also, other layers, e.g. electro-optical layers, may be interposed between the organic and/or barrier layers.

In one embodiment, the groove 16 has an oblique angle with respect to the surface of the substrate, i.e. the angle α between a side wall of the groove and the substrate surface is less than 90 degrees, preferably less than 80 degrees, e.g. in a range between 50 - 80 degrees. The smaller angle α may be beneficial e.g. when a groove such as shown is filled by projecting sealing material from the top into the groove. This may particularly beneficial for an embodiment wherein the groove is not completely filled, e.g. to sufficiently cover the side walls. Accordingly the sealed groove may comprise an inverted frustro-conical shape.

FIGs 2A and 2B show schematic cross-section views of embodiments of a barrier foil 10 with integrated electrical circuit 17a,17b electrically connected to an electrical device stack 30 disposed on top of the foil 10. In one embodiment, an electrode layer 31,33 of the device structure 30 is electrically connected to the sealing material 17m. FIG 2A illustrates how a bottom electrode 31 of the device stack 30 is connected by a shunt 47 to the sealing material 17m. FIG 2B illustrates how a top electrode 33 of the device stack 30 is connected by a shunt 47 to the sealing material 17m. In one embodiment, a part 31e,33e of the respective electrode layer 31,33 extends from underneath a sealing layer 40 applied on top of the device structure 30 wherein the extended part of the electrode layer is electrically connected to the sealing material 17m. While the present embodiments show the device stack connected by a separate shunt material, alternatively, or in addition, the layer 31 or 33 can be directly in contact with the sealing material 17m.

In the shown embodiment, the device stack 30 comprises an electro-optical layer 32 between the electrode layers 31 and 33. The electro-optical layer 32 may e.g. comprise a light emitting layer or a light absorbing layer. For example, the device stack 30 may form part of an OLED or OPV device. Advantageously, the barrier foil formed by the layers 11,12,13 may prevent external moisture and/or oxygen 19 from reaching the device stack, at least from the bottom. The sealing material 17m may prevent the external moisture and/or oxygen 19 from penetrating the organic layer 12 from a side 21 of the foil. At the same time the sealing material 17m may form part of the electrical circuit of the device stack 30.

According to one aspect, the present disclosure provides a barrier foil 10. The barrier foil comprises a layered structure comprising an organic layer 12 sandwiched between barrier layers 11, 13. The barrier foil 10 comprises a sealed groove 17 alongside a perimeter of the barrier foil 10. The sealed groove 17 is formed by an elongated groove 16 extending partially through the barrier foil segment 10 from a face 10a of the barrier foil 10, partly or all the way through at least the organic layer 12. The elongated groove 16 filled with a sealing material 17m. The sealed groove 17 and the barrier layers 11, 13 are arranged for enclosing organic material 12m in at least part of the organic layer 12 and adapted for preventing, in use, external moisture and/or oxygen 19 from reaching the organic material 12m. The sealing material 17m comprises an electrically conductive material forming an electrical circuit.

In one embodiment, the barrier foil is part of OLED or OPV device stack. The device stack may further comprise one or more electro-optical layers 31,32,33 disposed on a face of the barrier foil 10. The barrier foil 10 is configured to seal the electro-optical layers at least from one side for preventing external moisture and/or oxygen 19 from reaching the electro-optical device structure 30. The sealing material 17m forms an electrical circuit, e.g. busbar, that is electrically connected to the electro-optical device structure 30.

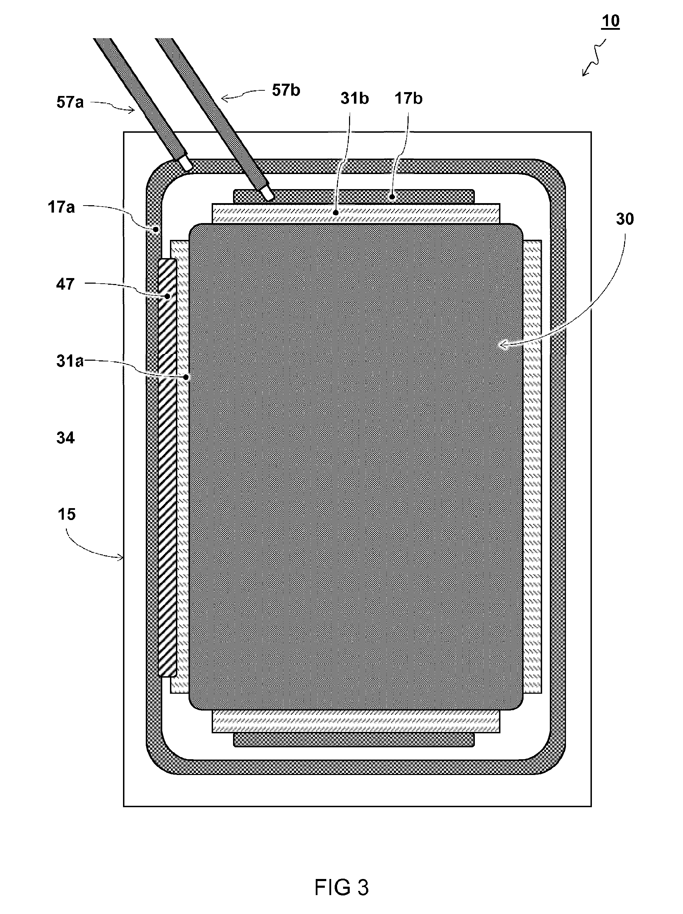

FIG 3 shows a schematic top view of a foil segment 10 with electrical connections 57a,57b applied to the circuit. In one embodiment, the sealed groove 17a extends along a perimeter 15. In one embodiment, a device stack 30 is disposed on the foil inside the perimeter of the foil. In one embodiment, a first electrode 31 of the device stack 30 is electrically connected to a first sealed groove 17a in the barrier foil. In another or further embodiment, a second electrode 32 of the device stack 30 is electrically connected to a second sealed groove 17b in the barrier foil. Either one or both of the electrical connections may be facilitated by a shunt 31a,31b. In one embodiment, one or more sealed grooves 17a,17b are electrically connected to an external power source or power drain, e.g. by means of electrodes 57a and 57b, e.g. to power the device 30 or receive electrical energy therefrom. Whereas the figure shows a rectangular foil segment, this may be any other desired shape such as a square, triangle, circle, oval, star, or any custom shape. The sealed groove / busbar may generally follow a contour of the segment perimeter 15, e.g. being approximately parallel to the segment perimeter 15.

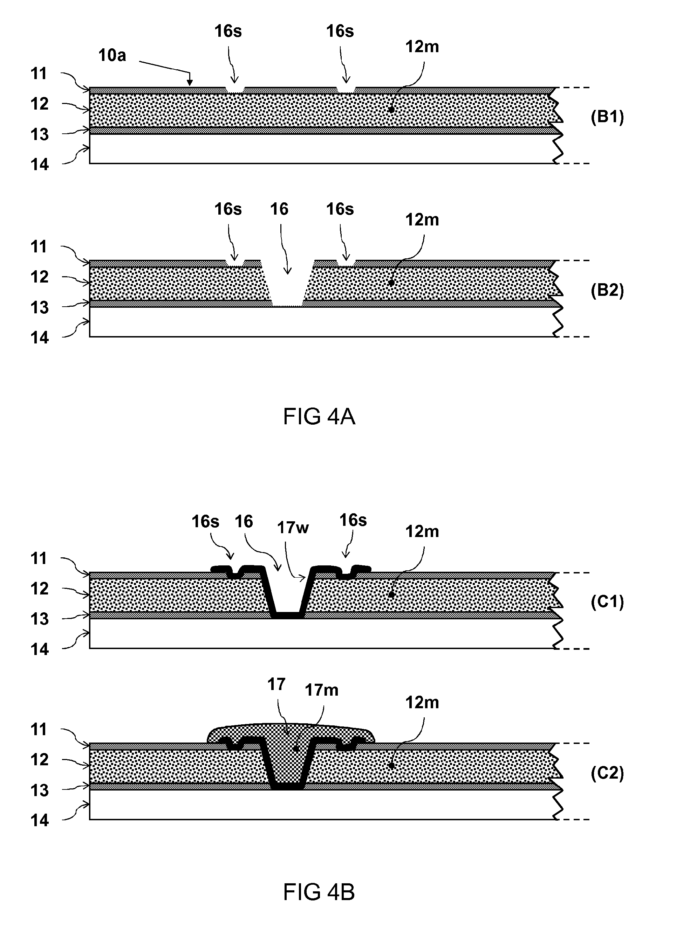

FIG 4A shows a schematic embodiment of a method for cutting into a barrier foil. In one embodiment, the method comprises (B1) providing two shallow cuts 16s in the barrier foil 10 from one face 10a of the barrier foil 10 into at least a top barrier layer 11. The method further comprises (B2) cutting in between the shallow cuts 16s forming the elongated groove 16 at least partially through the organic layer 12 of the barrier foil 10. In one embodiment, the elongated groove 16 is cut deeper into the barrier foil than the shallow cuts 16s.

FIG 4B shows a schematic embodiment for filling cuts in the barrier foil. In one embodiment, the method comprises (C1) depositing a wetting material 17w at least into the elongated groove 16 before depositing the sealing material 17m, for improving bonding of the sealing material 17m in the groove 16 by means of the wetting material 17w. In another or further embodiment, the method comprises (C2) depositing the sealing material 17m to cover both the shallow cuts 16s and the elongated groove 16. It is noted that the depositing of the wetting layer 17 (step C1) may also be omitted when covering the grooves 16s and 16 with sealing material 17m.

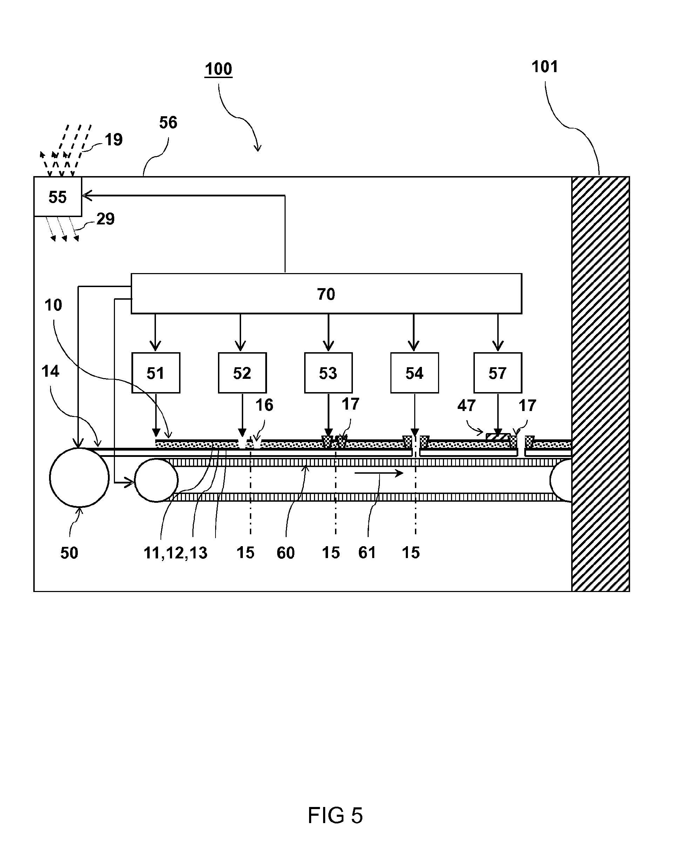

FIG 5 shows a system 100 for providing an electrical circuit on a barrier foil 10. The system comprises a foil providing means 50, 60, a groove forming means 52, a groove sealing means 53, and a controller 70.

The controller 70 is arranged (i.e. programmed and connected) for controlling the foil providing means 50, 60 for providing the continuous barrier foil 10. The continuous barrier foil 10 comprises a continuous layered structure comprising an organic layer 12 sandwiched between barrier layers 11 and 13.

The controller 70 is further arranged for controlling the groove forming means 52 for partially cutting through the continuous barrier foil 10 forming an elongated groove 16 into the continuous barrier foil 10. The elongated groove 16 thus cut extends alongside a predefined segment perimeter 15 on the continuous barrier foil 10. The elongated groove 16 extends from one face of the continuous barrier foil 10 all the way through at least one of the barrier layers (11) and the organic layer 12. The controller in combination with the groove forming means are thus arranged to cut at least through the barrier layer 11 and the organic layer 12. The controller may e.g. comprise a memory with instructions for determining an absolute or relative position of the predefined segment perimeter 15 and/or the elongated groove 16. The instructions may also comprise a duration and/or cutting power applied by the groove forming means 52 on the layered structure to cut at least through the barrier layer 11 and the organic layer 12

The controller 70 is further arranged for controlling the groove sealing means 53 for depositing a sealing material into the elongated groove 16 thus forming a sealed groove 17 alongside the segment perimeter 15. The sealed groove 17 and the barrier layers 11, 13 are arranged for enclosing organic material 12m in at least part of the organic layer 12 and adapted for preventing, in use, external moisture and/or oxygen from reaching the organic material 12m when the barrier foil segment 20 is cut from the continuous barrier foil 10 along the pre-defined segment perimeter 15 through the continuous barrier foil 10.

In one embodiment, the groove sealing means 53 comprises a supply with an electrically conductive material as the sealing material 17m for forming the electrical circuit by means of the deposited sealing material 17m.

In one embodiment the system further comprises a foil cutting means 54. The controller 70 is further arranged for controlling the groove forming means 52 to form the elongated groove 16 extending alongside a predefined segment perimeter 15 on the barrier foil 10, the elongated groove 16 extending from one face 10a of the barrier foil 10 all the way through at least the said organic layer 12 The controller 70 is further arranged for controlling the foil cutting means 54 for cutting through the barrier foil 10 along the segment perimeter 15. The sealed groove 17 formed parallel to the predefined segment perimeter 15 and adapted for preventing, in use, external moisture and/or oxygen 19 from reaching the organic material 12m when the barrier foil segment 20 is cut along the pre-defined segment perimeter 15 through the barrier foil 10. Alternative to cutting the foil 10 after dividing it into segments, the foil 10 may also be kept intact e.g. for further processing or storing the divided continuous foil back on a roll.

In one embodiment the system further comprises a shunt deposition means 57. The controller 70 is further arranged for controlling the shunt deposition means 57 for depositing an electrically conducting shunt 47 on top of the foil 10 wherein the shunt 47 is electrically connected to the sealing material 17m.

In the shown embodiment, the system 100 further comprises layer deposition means 51, arranged for providing one or more layers onto a foil substrate 14. The controller 70 is arranged for controlling the layer deposition means 51 for depositing a continuous layered structure on the foil substrate 14. The continuous layered structure comprises an organic layer 12 sandwiched between barrier layers 11,13 forming the continuous barrier foil 10. In one embodiment, the layer deposition means 51 comprises a barrier layer deposition means and an organic layer deposition means. Typically, the barrier layer deposition means comprises a barrier material supply that is, in use, filled with a barrier material to be deposited on the substrate 14 to form the barrier layers 11 and/or 13. Similarly, the organic layer deposition means comprises an organic material supply that is, in use, filled with organic material to be deposited on the substrate 14 to form the organic layer 12.

In one embodiment, the foil providing means comprises a foil supply 50 on a roll and a foil transport system 60, wherein the foil transport system 60 carries the foil along the said sequence of foil treatments, wherein the sequence comprises a groove forming means arranged to form a groove in the barrier foil after a outer top barrier layer 11 is deposited on the organic layer 12 by a barrier layer deposition means.

In the shown embodiment, the foil substrate 14 is supplied from a foil supply roll 50 and transported by a foil conveyor system 60, e.g. an endless conveyor belt moving the foil in direction 61. Also other known means for transporting a foil may be used, e.g. rollers. The layers deposited onto the substrate 14 may form the continuous barrier foil 10. The substrate 14 may be part of the continuous barrier foil 10 or may be removed after layer deposition. Alternative to the shown embodiment, the continuous barrier foil 10 may also be directly provided, e.g. from a supply roll comprising the continuous barrier foil 10. The continuous barrier foil 10 may e.g. be manufactured in a preceding R2R process.

Alternative to providing the continuous barrier foil 10 from a roll, the continuous barrier foil 10 may also be provided as a sheet. E.g. a continuous barrier foil sheet may be divided into barrier foil segments by the system and process described herein. E.g. a foil segment 20 can be divided and cut from a continuous barrier foil sheet 10. A foil providing means may thus include any and all means for providing a foil.

In the shown embodiment, the system 100 further comprises an enclosure 56. The continuous barrier foil is processed inside the enclosure. An environmental control system 55 may be used to provide a low-humidity and/or low oxygen environment inside the enclosure 56. While the continuous barrier foil 10 is cut it may be kept from external moisture and/or oxygen 19 by environmental control system 55 and/or the enclosure 56. For example, dry nitrogen may be flushed through the enclosure for providing an environment with low humidity and low oxygen. Alternatively or in addition, the enclosure may be kept at low pressure, e.g. vacuum. The partially cutting B the continuous barrier foil 10 may thus be preceded by bringing the foil into an environment having low moisture and/or low oxygen adapted to prevent deterioration of the organic material 12m when exposed to said environment.

In the shown embodiment, the foil is further processed in processing system 101. Further processing may include additional layer deposition. Further processing may take place on cut foil segments or on a non-cut foil. An advantage of cutting the foil segments may be to more easily handle them, e.g. when gluing separate foil segments. Keeping the divided foil segments together in a continuous foil facilitates further R2R processing.

In an embodiment (not shown), an OLED layer is deposited onto the divided barrier foil segments 20. The OLED layer may comprise additional layers such as, but not limited to light emitting layers, cathode and anode layers, and/or charge injection layers. The OLED layer may be covered by a second barrier foil layer. The second barrier foil layer may be deposited onto the OLED layer or glued to the OLED layer. The barrier foil segments may enclose the OLED layer. The barrier foil segments may be fused together or sealed in another way at the edges. In this way the OLED layer may be protected from moisture and/or oxygen. In another embodiment, the continuous barrier foil comprises an OLED layer as one of its organic layers. The OLED layer is thus sealed by sealing the continuous barrier foil.

While example systems were shown for providing a foil, digging grooves in a foil, sealing the grooves, depositing further layers, and/or cutting a foil, also alternative systems and means may be used for achieving similar results. Whereas in the discussion, reference is made to a foil, the same methods and systems may be applicable to other structures, e.g. rigid substrates and layers. Optical components such as lasers, mirrors, lenses, etc may be combined or split up into one or more alternative optical components having similar effect. Similarly electrical components such as controllers and processors may be split into separate and/or dedicated components or be comprised in integrated circuitry.

The various elements of the embodiments as discussed and shown offer certain advantages, such providing an electrical circuit part on a barrier foil that also provides sealing of the barrier foil. Of course, it is to be appreciated that any one of the above embodiments or processes may be combined with one or more other embodiments or processes to provide even further improvements in finding and matching designs and advantages. It is appreciated that this invention offers particular advantages to the prevention of moisture and/or oxygen from reaching an organic layer, and in general can be applied for any application wherein electrical circuits are applied to a barrier foil. The disclosed methods may also be advantageously applied for adding circuits and/or sealing components of non-organic materials, e.g. a Copper indium gallium (di)selenide (CIGS) based solar cell. Instead of a barrier foil, the present disclosure may also find application in sealing other types of layered structures. Alternative or in addition to providing protection against environmental influences, the sealing may also be arranged for other functions. Steps need not necessarily be executed in the order as presented, e.g. the barrier foil may be cut into foil segments prior to or during digging and/or sealing the grooves while resulting in similar advantages. The cutting can also be omitted, e.g. the circuit lanes formed by the filled grooves can be applied anywhere on the foil, not only on the edges near the foil perimeter.

Finally, the above-discussion is intended to be merely illustrative of the present systems and/or methods and should not be construed as limiting the appended claims to any particular embodiment or group of embodiments. The specification and drawings are accordingly to be regarded in an illustrative manner and are not intended to limit the scope of the appended claims. In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. The mere fact that certain measures are recited in mutually different claims does not indicate that a combination of these measures cannot be used to advantage. In particular, all working combinations of the claims are considered inherently disclosed.

## Claims

1. Method for providing a barrier foil (10) comprising an electrical circuit, the method comprising
(A) providing the barrier foil (10) comprising a layered structure comprising an organic layer (12) sandwiched between barrier layers (11, 13);
(B) partially cutting through the barrier foil (10) forming an elongated groove (16) from one face (10a) of the barrier foil (10) into the barrier foil (10); and
(C) depositing a sealing material (17m) into the elongated groove (16) thus forming a sealed groove (17), the sealed groove (17) and the barrier layers (11, 13) arranged for enclosing organic material (12m) in at least part of the organic layer (12) and adapted for preventing, in use, external moisture and/or oxygen (19) from reaching the organic material (12m), wherein the sealing material (17m) comprises an electrically conductive material forming the electrical circuit.

2. Method according to claim 1, comprising
(D) applying an electrically conducting shunt (47) on top of the foil (10), wherein the shunt (47) is electrically connected to the sealing material (17m).

3. Method according to any of the preceding claims, wherein the elongated groove (16) extends alongside a predefined segment perimeter (15) on the barrier foil (10), the elongated groove (16) extending from one face (10a) of the barrier foil (10) all the way through at least the organic layer (12), the method comprising
(E) cutting through the barrier foil (10) along the predefined segment perimeter (15), wherein the sealed groove (17) formed parallel to the predefined segment perimeter (15) is adapted for preventing, in use, external moisture and/or oxygen (19) from reaching the organic material (12m) when the barrier foil (10) is cut along the pre-defined segment perimeter (15) through the barrier foil (10).

4. Method according to any of the preceding claims, wherein an electrical device (30) is disposed onto the foil (10) and electrically connected to the sealing material (17m).

5. Method according to any of the preceding claims, wherein the sealing material (17m) has an electric conductivity (σ) of more than 10⁶ siemens per metre (S/m).

6. Method according to any of the preceding claims, wherein the sealing material (17m) comprises solder.

7. Method according to any of the preceding claims, comprising depositing a wetting material (17w) at least into the elongated groove (16) before depositing the sealing material (17m), for improving bonding of the sealing material (17m) in the groove (16) by means of the wetting material (17w).

8. Method according to any of the preceding claims, comprising providing two shallow cuts (16s) in the barrier foil (10) from said one face (10a) of the barrier foil (10) into at least a top barrier layer (11); and subsequently cutting in between the shallow cuts (16s) forming the elongated groove (16) at least partially through the organic layer (12) of the barrier foil (10), wherein the elongated groove (16) is cut deeper into the barrier foil than the shallow cuts (16s).

9. Method according to claim 8, wherein the sealing material (17m) is deposited to cover both the shallow cuts (16s) and the elongated groove (16).

10. Method according to any of the preceding claims, wherein the partially cutting (B) the barrier foil (10) to form the elongated groove is performed by irradiation of the barrier foil (10) with a laser (80) configured to provide a free form trajectory of the groove in the barrier foil (10).

11. System (100) for providing a barrier foil (10) comprising an electrical circuit, the system comprising a foil providing means (50, 60), a layer deposition means (51), a groove forming means (52), a groove sealing means (53), and a controller (70), the controller (70) arranged and programmed for
- controlling the foil providing means (50, 60) for providing a foil substrate (14);
- controlling the layer deposition means (51) for depositing a layered structure on the foil substrate (14), the layered structure comprising an organic layer (12) sandwiched between barrier layers (11, 13) forming the barrier foil (10);
- controlling the groove forming means (52) for partially cutting through the barrier foil (10) forming an elongated groove (16) into the barrier foil (10); and
- controlling the groove sealing means (53) for depositing a sealing material (17m) into the elongated groove (16) thus forming a sealed groove (17), the sealed groove (17) and the barrier layers (11, 13) arranged for enclosing organic material (12m) at least part of the organic layer (12) and adapted for preventing, in use, external moisture and/or oxygen (19) from reaching the organic material (12m), wherein the groove sealing means (53) comprises a supply with an electrically conductive material as the sealing material (17m) for forming the electrical circuit by means of the deposited sealing material (17m).

12. System (100) according to claim 11, further comprising a shunt deposition means (57), wherein the controller (70) is further arranged for
- controlling the shunt deposition means (57) for depositing an electrically conducting shunt (47) on top of the foil (10) wherein the shunt (47) is electrically connected to the sealing material (17m).

13. System (100) according to claim 11 or 12, further comprising a foil cutting means (54), wherein the controller is arranged for
- controlling the groove forming means (52) to form the elongated groove (16) extending alongside a predefined segment perimeter (15) on the barrier foil (10), the elongated groove (16) extending from one face (10a) of the barrier foil (10) all the way through at least the said organic layer (12); and
- controlling the foil cutting means (54) for cutting through the barrier foil (10) along the segment perimeter (15), wherein the sealed groove (17) formed parallel to the predefined segment perimeter (15) is adapted for preventing, in use, external moisture and/or oxygen (19) from reaching the organic material (12m) when the barrier foil segment (20) is cut along the pre-defined segment perimeter (15) through the barrier foil (10).

14. Barrier foil (10) comprising a layered structure comprising an organic layer (12) sandwiched between barrier layers (11, 13), the barrier foil (10) comprising a sealed groove (17) alongside a perimeter of the barrier foil (10), the sealed groove (17) formed by an elongated groove (16) extending partially through the barrier foil segment (10) from a face (10a) of the barrier foil (10) all the way through at least the organic layer (12); the elongated groove (16) filled with a sealing material (17m); the sealed groove (17) and the barrier layers (11, 13) arranged for enclosing organic material (12m) in at least part of the organic layer (12) and adapted for preventing, in use, external moisture and/or oxygen (19) from reaching the organic material (12m), wherein the sealing material (17m) comprises an electrically conductive material forming an electrical circuit.

15. OLED or OPV device stack comprising
- the barrier foil (10) according to claim 14, and
- one or more electro-optical layers (31,32,33) disposed on a face of the barrier foil (10); wherein the barrier foil (10) is configured to seal the electro-optical layers at least from one side for preventing external moisture and/or oxygen (19) from reaching the electro-optical device structure (30), and wherein the sealing material (17m) forms a busbar that is electrically connected to the electro-optical device structure (30).
